# FASCICULE DE BREVET EUROPEEN

(11) **EP 0 917 687 B1**
(45) Date de publication et mention de la délivrance du brevet: **18.04.2001**
(21) Numéro de dépôt: 96946394.2
(22) Date de dépôt: 05.08.1996
(51) Int. Cl.: G06K 19/077

(54) **PERFECTIONNEMENT A UN PROCEDE DE REALISATION DE CARTES A MEMOIRE**
VERBESSERUNG EINES HERSTELLUNGSVERFAHRENS EINER SPEICHERKARTE
IMPROVEMENT TO A METHOD FOR MAKING SMART CARDS

(43) Date de publication de la demande: 26.05.1999
(73) Titulaire: GEMPLUS, 13881 Gémenos cedex (FR)
(72) Inventeur: PERMINGEAT, Vincent, F-13011 Marseille (FR)
(86) Numéro de dépôt international: FR9601246
(87) Numéro de publication internationale: WO9806062

(56) Documents cités:
- EP-A- 0 717 371
- DE-A- 4 229 639
- US-A- 4 871 405
- US-A- 4 903 118
- US-A- 5 169 056

## Description

La présente invention concerne un perfectionnement à un procédé de réalisation de cartes à mémoire, du type constitué d'un corps de carte et d'un module électroniques.

Parmi les procédés existants, on connaît un procédé qui consiste à fournir un corps de carte comportant une cavité, un module électronique comportant principalement des plages de contact et une pastille semi-conductrice contenant un circuit intégré, et à fixer le module électronique dans ladite cavité à l'aide de moyens de collage tels qu'une colle cyanocrylate. En général, l'opération de collage comprend une opération préalable de dépose de la colle, une opération d'insertion du module dans la cavité et une opération de pressage pendant un temps prédéterminé.

Un tel procédé est connu de DE-C-42 29 639.

Toutefois, la mise en oeuvre pratique d'un tel procédé, communément appelé encartage, à une échelle industrielle automatisée nécessitant des opérations distinctes cadencées effectuées à différents postes ainsi que des transferts de cartes d'un poste à l'autre à un rythme élevé, de l'ordre de quelques milliers de cartes à l'heure, est source de divers problèmes qui influent sur la qualité du produit final.

En particulier, l'inventeur a constaté que les cartes obtenues par collage en suivant les opérations exposées ci-dessus présentaient souvent des défauts majeurs.

Parmi ces défauts, on trouve principalement des défauts de centrage du module dans la cavité. En effet, malgré une insertion du module correctement centrée dans la cavité, l'inventeur a constaté en fin de collage que des modules étaient décentrés, c'est à dire qu'il se retrouvaient décalés par rapport à la position initiale d'insertion. Les décalages types constatés se traduisent soit par une légère rotation, soit par une translation, soit les deux à la fois à l'intérieur de la cavité, soit dans des cas extrêmes en dehors de la cavité avec un chevauchement d'un bord des plages de contact sur la surface du corps de carte.

L'inventeur a trouvé que le décentrage résulte notamment de forces engendrées sur la carte au cours de son déplacement d'un poste à un autre, notamment des forces brutales d'accélération ou de décélération engendrées respectivement par le départ du poste d'insertion et l'arrêt de la carte au poste de pressage.

Le décentrage peut également résulter de contraintes résiduelles présentes dans le module qui tendent à lui donner une légère incurvation. Dans ce cas, le module risque de sortir de la cavité à chaque accélération ou décélération ci-dessus.

On trouve également des défauts relatifs à une mauvaise adhérence du module sur le corps de carte. Dans de telles situations, la carte ne peut satisfaire à des critères de résistance mécanique en flexion /torsion ou à l'arrachement imposés par les normes en vigueur (ISO, AFNOR).

Il est donc nécessaire de résoudre ces problèmes sans diminuer les cadences de production.

La présente invention a pour objectif de proposer un perfectionnement au procédé de collage de module électronique dans le corps de carte qui puisse être compatible avec une production industrielle automatisée et cadencée à un rythme très élevé, sans pour autant engendrer des défauts, soit de centrage du module, soit d'adhérence.

A cet effet, la présente invention a pour objet un procédé de réalisation d'une carte à module électronique selon lequel on fournit un corps de carte muni d'une cavité, un module électronique de dimensions correspondant à ladite cavité, au moins un premier moyen de collage apte à adhérer au corps de carte et au module, on dépose au moins ledit premier moyen de collage dans ladite cavité ou sur le module, on insère ledit module dans la cavité dans une position sensiblement centrée et on presse ledit premier moyen de collage entre le corps de carte et le module.

Le procédé est caractérisé en ce qu'il comporte en outre une étape consistant à utiliser un deuxième moyen de collage présentant des propriétés gluantes et permettant de maintenir le centrage du module dans la cavité au moins jusqu'à ce que ledit premier moyen de collage soit pressé.

Grâce à l'emploi de ce deuxième moyen de collage ayant des propriétés gluantes (adhérence et forte viscosité), les cartes peuvent être soumises à toutes accélérations ou décélérations au cours de leur fabrication sans que le décentrage en soit affecté.

En outre, il est possible de diminuer significativement le temps consacré à l'insertion du module et donc d'augmenter les cadences de production.

L'invention permet également d'optimiser la sélection du premier moyen de collage et de le mettre en oeuvre dans des conditions optimales de manière à mieux résister à des efforts d'arrachement du module et à des efforts de flexion/torsion.

Selon une mise en oeuvre avantageuse du procédé, on sélectionne le deuxième moyen de collage parmi les matières aptes après traitement à résister à des efforts d'arrachement et/ou de flexion/torsion, et on met en oeuvre ladite matière de manière qu'elle produise ses effets de résistance à de tels efforts.

Ainsi, le deuxième moyen de collage lorsqu'il est traité convenablement, a la fonction supplémentaire de contribuer avec le premier moyen de collage à résister à des efforts d'arrachement et/ou de flexion/torsion imposés par les normes en vigueur visées supra.

Selon un mode de mise en oeuvre préféré, on utilise une résine époxyde photo-activable en tant que deuxième moyen de collage. Cette résine peut être soumise à un rayonnement ultraviolet préalablement à l'insertion du module si on souhaite qu'elle assure en plus à terme une fonction de résistance mécanique et qu'elle contribue ainsi à la résistance mécanique de l'ensemble constitué par le corps de carte et le module.

Grâce à ce mode de mise en oeuvre, on peut favoriser l'activation du point du deuxième moyen de collage de manière efficace et indépendante des conditions ambiantes opératoires. En outre, on peut agir aisément sur la cinétique de la réaction de polymérisation suivie par la résine en agissant sur l'intensité et le temps d'exposition de celle-ci au rayonnement ultraviolet.

Selon une autre caractéristique permettant de bons résultats de maintien du module, la résine a une viscosité de 50 000 m.P/seconde.

Selon une autre caractéristique permettant des bons résultats et pour des raisons de commodité de mise en oeuvre du procédé, on dépose une goutte de 0,003 gramme au centre de la cavité, et on expose la résine au rayonnement de manière que son temps d'ouverture soit égal à environ 60 secondes.

Conformément à un deuxième mode de mise en oeuvre du procédé, on utilise un gel de colle cyanocrylate en tant que deuxième moyen de collage que l'on met en oeuvre à des conditions de température et d'hygrométrie appropriées préalablement à l'insertion du module.

L'utilisation de ce gel est avantageuse car le gel peut être mis en oeuvre dans des conditions économiques.

Selon une autre caractéristique de mise en oeuvre du gel avec de bons résultats de maintien du module, on dépose une goutte au centre de la cavité, les conditions de température et d'hygrométrie permettant un temps d'ouverture égal à environ 60 secondes.

Conformément à une autre caractéristique du procédé, selon le premier où deuxième mode de mise en oeuvre, le procédé peut consister à utiliser une colle du type cyanocrylate en tant que premier moyen de collage.

Cette colle a l'avantage d'être commode et économique à mettre en oeuvre.

Ce premier moyen de collage peut être déposé en une quantité permettant de couvrir une surface de collage comprise entre 50 et 100 % de la surface de ladite cavité, après pressage, et sous forme d'au moins quatre points latéraux dans le logement des plages de contact sous une température comprise entre 18 à 24 °C et un taux hygrométrique compris entre 60 et 75 %.

De telles conditions opératoires permettent une production industrielle cadencée à un rythme élevé en présentant peu de défauts, le premier moyen de collage étant une colle cyanocrylate.

Selon une autre caractéristique préférée du procédé, on dépose de la colle cyanocrylate juste avant l'étape d'insertion.

De cette manière, on obtient de meilleurs résultats d'adhérence de la colle cyanocrylate au module.

Selon une autre caractéristique du procédé, on choisit la colle cyanocrylate de préférence relativement pure, le temps d'ouverture de la colle cyanocrylate étant égal à environ 60 secondes dans les conditions opératoires ci-dessus.

Ainsi, cette colle permet d'assurer un meilleur collage puisqu'elle est relativement lente à polymériser.

D'autres caractéristiques et avantages de l'invention apparaîtront plus clairement à la lecture de la description qui va suivre de deux modes principaux de mise en oeuvre donnés à titre d'exemple uniquement. Elle doit être lue en référence aux dessins annexés sur lesquels :
- la figure 1 représente un corps de carte utilisable dans le procédé de l'invention;
- la figure 2 représente en coupe un module électronique utilisable dans le procédé de l'invention;
- la figure 3 représente une vue de dessus d'un film support de modules électroniques;
- la figure 4 représente une vue schématique montrant l'agencement du module par rapport à la carte.
- la figure 5 représente un schéma d'une cavité vue de dessus avec un tracé pour le dépôt des points de colle;
- la figure 6 représente les surfaces d'adhérence des moyens de collage sur la cavité après pressage;
- les figures 7 à 12 représentent les différentes étapes du procédé, ou différents postes opératoires d'une installation;
- la figure 13 représente des moyens de pressage;
- la figures 14 représente une vue de dessus d'un exemple d'installation pour la mise en oeuvre du procédé à cadence élevée.
- la figure 15 représente les moyens de mouillage à l'alcool.

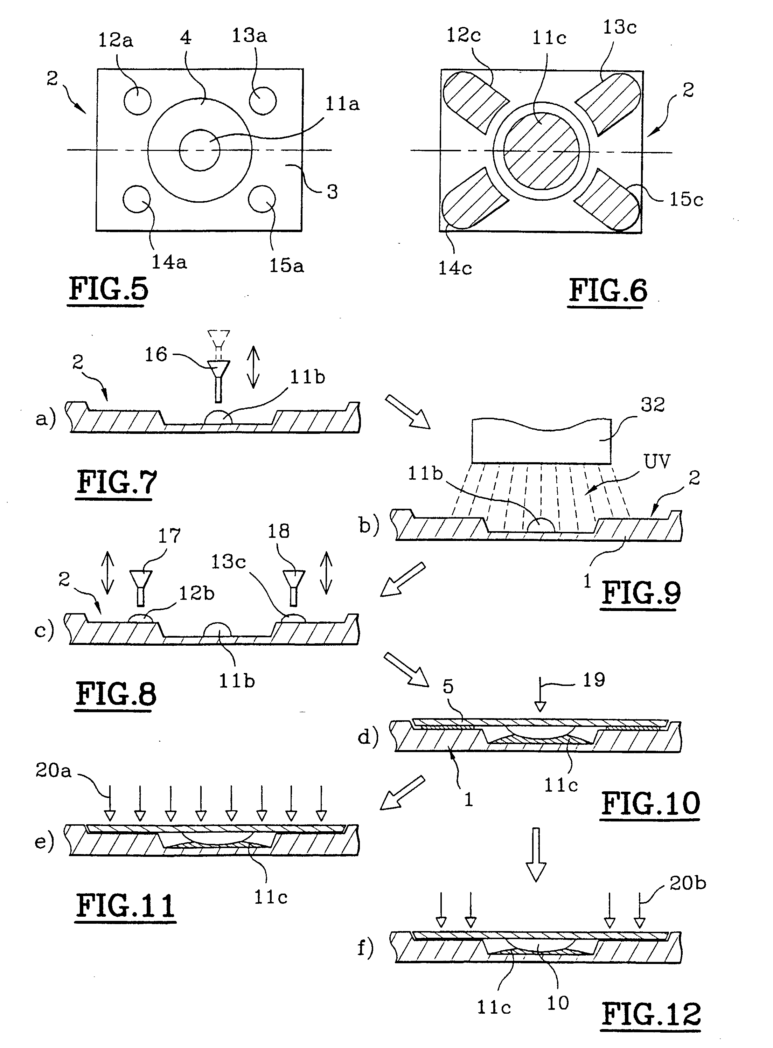

On va maintenant décrire le procédé de l'invention conformément à un premier mode de mise en oeuvre en référence aux figures 5 à 12.

Le procédé de l'invention nécessite de fournir un corps de carte muni d'une cavité et un module électronique de dimensions correspondant à ladite cavité.

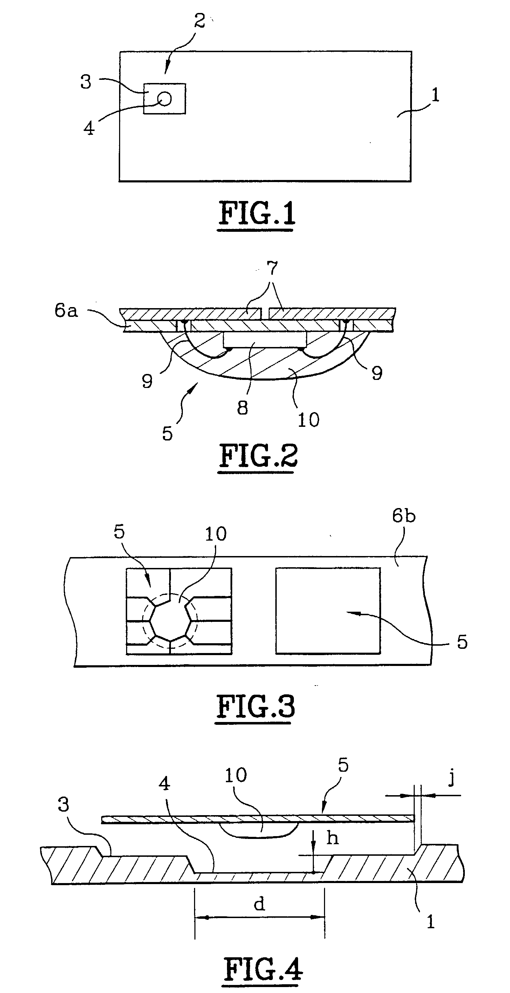

La figure 1 représente un exemple de corps de carte à mémoire 1 utilisable par le procédé. Il comprend une cavité 2 qui peut être obtenue par moulage en même temps que le corps de carte ou par usinage.

Les corps de carte de ce type sont normalisées par les normes ISO, AFNOR, et possèdent par conséquent des dimensions prédéterminées.

La cavité doit permettre de recevoir le module. Elle peut donc avoir des formes variées selon le module retenu. Elle est constituée dans cet exemple de deux évidements, un premier évidement 3 de forme générale rectangulaire débouchant à la surface avant de la carte, et un deuxième évidement 4 de forme générale circulaire plus profond que le premier disposé au centre du rectangle et débouchant dans le fond du premier. Le deuxième évidement a un diamètre d de 8,2 mm et une hauteur h de 0,6 mm (figure 4).

La matière utilisée, généralement le plastique, dépend des applications. Ainsi par exemple, les cartes à mémoire téléphoniques ou télécartes sont en ABS (acrylonitrile butadiène styrène), elles peuvent être aussi en PVC (chlorure de polyvinyle), ou sous forme feuilletée avec du polycarbonate (PC) par exemple en PC/ABS , ou en PC/PVC.

Dans l'exemple, on a utilisé une cavité conforme à la norme ISO et de l'ABS pour la matière du corps de carte.

Le module électronique 5 (figure 2 et 3) comporte généralement un film support 6a en matière synthétique isolante, de plages de contact 7 en matériau conducteur, une pastille de silicium 8 contenant un circuit intégré, des fils de liaison 9 de la pastillé aux plages de contact et une résine d'enrobage 10 recouvrant la pastille et les fils de liaison.

L'enrobage, généralement en résine époxy thermodurcissable, forme un bossage qui peut avoir des dimensions irrégulières notamment en épaisseur. Dans le meilleur des cas, ce bossage peut être arasé par fraisage selon une côte d'épaisseur plus précise de manière à faciliter l'opération de collage du module dans le corps de carte. De préférence, l'invention vise à utiliser directement le bossage sans qu'il ait été fraisé.

Le module (figures 2 et 3) peut être de plusieurs types, par exemple du type « LFCC » (Lead Frame Contre Collé) avec un film support en polyimide ou d'un type comportant un film support en époxy.

Dans l'exemple, le module est du type « LFCC » et présente donc une surface inférieure en polyimide. Il est fourni à partir d'un film continu 6b (figure 3) et présenté sur bobine.

La cavité de la carte est destinée à recevoir le module comme illustré schématiquement à la figure 4. Pour cela, l'évidement 4 correspond au bossage 10, tandis que l'évidement 3 correspond aux plages de contact 5 avec un jeu nécessaire d'assemblage (J). Ce jeu est tel qu'une simple rotation du module dans le plan de la carte ou une simple translation dans ce même plan, est notable à l'oeil nu et constitue de ce fait un défaut de centrage.

Le procédé consiste également à fournir au moins un premier moyen de collage apte à adhérer au corps de carte et au module. L'adhérence s'effectue généralement après activation ou traitement. Dans le cas des cartes à module électronique, les moyens de collage assurent la fonction de résister à des efforts d'arrachement et/ou de flexion/torsion selon les normes visées supra.

Le premier moyen de collage peut être de plusieurs natures. Il peut par exemple être à base d'une colle cyanocrylate liquide déposée sous forme de points ou de cordons. Il peut également être en matière thermo-adhésive, ou thermoplastique et déposé sous forme de film. Il peut être ajouté au corps de carte ou faire partie de celui-ci comme par exemple dans le brevet FR 2 579 799. Il peut être déposé sur le corps ou sur le module.

Dans les exemples décrits, on a utilisé une colle cyanocrylate que l'on a déposé dans la cavité conformément à un tracé préféré tel que décrit infra et illustré à la figure 5.

Conformément au procédé, celui-ci comprend des étapes selon lesquelles on dépose ledit premier moyen de collage dans la cavité ou sur le module, de préférence dans la cavité, on insère ledit module dans la cavité dans une position sensiblement centrée et on presse au moins ledit premier moyen de collage entre la carte et le module. De telles étapes seront décrites en détail dans un exemple de mise en oeuvre illustré aux figures 7 à 12.

Le procédé de l'invention est caractérisé en ce qu'il comporte en outre une étape consistant à fournir et à déposer également dans la cavité, un deuxième moyen de collage apte au moins à maintenir le centrage du module dans la cavité (à l'encontre de forces tendant à le décentrer) au moins jusqu'à ce que ledit premier moyen de collage soit pressé.

Selon l'invention, le deuxième moyen de collage utilisable comprend des matières aptes à présenter des propriétés gluantes. On entend par matière gluante une matière qui non seulement est adhérente notamment aux matières plastiques employées pour les corps de carte mais qui présente une viscosité élevée comme expliquée ci-après. L'adhérence doit être telle que le module ne se décolle pas sous les forces qu'il rencontre jusqu'au pressage. Comme exemple d'une telle matière on peut citer notamment une résine époxy mono-composant, un gel de colle cyanocrylate, une résine époxy thermodurcissable etc. Ces matières doivent être en outre très visqueuses comparativement à une colle cyanocrylate couramment employée de viscosité égale à environ 190 mP/s. On considère que la matière est très visqueuse par rapport à la colle cyanocrylate ci-dessus, dès lors que la viscosité de la matière est supérieure à 10 fois la viscosité de- la colle cyanocrylate ci-dessus. De préférence, on utilise une viscosité supérieure d'un facteur 100.

Dans l'exemple, on a utilisé une résine époxyde mono-composant photo-activable (bien qu'elle ne soit pas activée dans cette exemple) qui est avantageuse par sa présentation en mono-composant et qui adhère bien à l'ABS et au film du module en polyimide. Dans l'exemple, cette résine est déposée dans la cavité conformément à une étape illustrée à la figures 7.

Une viscosité de cette résine égale à 50 000 P/seconde a donné un excellent maintien du module en position centrée lorsqu'il est soumis à des accélérations équivalentes à celles existant dans une installation industrielle à cadence élevée visée par l'invention et dont un exemple est décrit infra.

Le volume total de la matière gluante dépend notamment de l'endroit où elle est déposée (volume disponible dans la cavité), de ses propriétés d'adhérence, de sa viscosité et des forces à l'encontre desquelles elle doit résister.

Elle peut avoir un volume total correspondant à une quantité comprise entre 0,002 et 0,004 gramme lorsqu'elle est déposée en un seul point. Ce volume peut toutefois être fractionné en plusieurs points, par exemple quatre points de 0,001 gramme dans le cas où la résine serait déposée latéralement dans le premier évidement.

Dans l'exemple, la résine ayant conduit à un excellent maintien du module avec une viscosité de 50 000 mP/s a été déposée sous forme d'une goutte d'un volume correspondant à 0,003 gramme au centre de la cavité. Ces valeurs sont compatibles avec une fabrication mettant en oeuvre par exemple une installation telle que décrite infra, dans laquelle les cartes sont transférées d'un poste à l'autre par des doigts qui viennent les frapper au niveau d'un chant arrière, ce qui entraîne des accélérations élevées.

On en déduit que dans des conditions de fabrication moins brutales c'est à dire avec des forces de transfert de la carte moins élevées, il est possible de réduire la quantité et/ou la viscosité de la résine.

La colle cyanocrylate utilisée dans les exemples comme premier moyen de collage est quant à elle déposée par point de colle dans le logement des plages de contact sous forme de quatre points de colle latéraux de 0,001 gramme chacun en suivant un tracé tel que décrit infra.

Divers moyens de dépose d'une goutte de colle cyanocrylate en une quantité déterminée et à un instant déterminé connus de l'homme du métier peuvent être utilisés. Il en est de même pour les moyens de dispense de la résine. La résine utilisée est de préférence du type mono-composant et tixotropique de manière à permettre une dispense qui soit compatible avec des cadences élevées de fabrication.

Le choix d'une matière très visqueuse pour une installation industrielle nécessitant une dispense très rapide pour respecter des cadences élevées va à l'encontre du préjugé selon lequel, pour dispenser une matière de plus en plus facilement et rapidement, il ne faut pas que la matière à dispenser soit de plus en plus visqueuse et adhérente. Or grâce à la nature tixotropique de la résine et malgré qu'elle soit très visqueuse et très adhérente, on peut la dispenser très facilement et très rapidement contrairement à ce préjugé. Une telle résine époxyde est fournie notamment par la société « Delo » sous la référence 4597.

En ce qui concerne les conditions ambiantes opératoires pour la colle cyanocrylate, II a été constaté qu'une température et une hygrométrie trop faibles conduisaient à une polymérisation trop lente de la colle et par conséquent entraînaient des risques de décollage et de décentrage du module (avec des risques de pollution de surface par polymérisation : « blooming »). A l'inverse, il a été constaté qu'une température et une hygrométrie trop élevées conduisaient à une polymérisation trop rapide de la colle, ce qui entraînaient d'une part également des risques de décollage, et avait d'autre part l'inconvénient de salir et de boucher une aiguille utilisée dans les moyens de dispense de colle. En outre, il a également été constaté qu'une hygrométrie trop faible entraînait des risques d'électricité statique. L'électricité statique a l'inconvénient d'attirer fortement des gouttes de colle cyanocrylate qui peuvent se déposer au hasard et générer des défauts.

- De bons résultats de résistance mécanique tant à l'arrachement qu'en flexion/torsion ont été obtenus lorsque la colle cyanocrylate est traitée ou mise en oeuvre en utilisant une température comprise entre 18 à 24 °C et un taux hygrométrique compris entre 60 et 75 %.

De manière avantageuse, grâce à la fonction de maintien immédiat du module par le deuxième moyen de collage conforme à l'invention, on peut choisir une colle cyanocrylate relativement pure qui produit ses effets dans un délai relativement long de manière à optimiser la qualité de l'adhérence, par exemple un délai supérieur à 60 secondes.

Dans cet exemple, la colle présente un temps d'ouverture égal à environ 60 secondes dans les conditions opératoires ambiantes ci-dessus. Le temps d'ouverture est le temps pendant lequel il est encore possible de faire adhérer un objet à la colle. Plus ce temps est long, meilleure est la polymérisation. Cette polymérisation peut se terminer le cas échéant après l'opération de pressage.

Dans l'exemple de mise en oeuvre du procédé, on utilise un tracé préféré tel qu'illustré à la figure 5 et qui montre la cavité avec les points 11a à 15a. Il comporte un point dit central 11a dans le logement 3 de la pastille, et quatre autres points dits latéraux 12a à 15a situés dans le logement 4 des plages de contact et dans les angles de ce logement.

Les quatre points latéraux permettent de couvrir, après pressage, une surface de collage comprise entre 50 et 100 % de la surface de ladite cavité (figure 6). Le pressage a été effectué de manière à obtenir une épaisseur de joint de colle cyanocrylate de l'ordre de 0,02 mm. L'empreinte laissée par l'étalement de chaque point de colle latéral définit une surface semi-circulaire 12c à 15c de forme générale en « U » qui s'étend sensiblement radialement depuis la proximité du bord du deuxième évidement 4 jusqu'à la proximité de l'angle du rectangle délimité par le premier évidement, la base du « U » étant orienté vers l'angle. Ainsi, on obtient une adhérence suffisante du module pour résister aux efforts imposés par les normes visées précédemment.

Conformément à un mode opératoire préféré de l'invention, on dépose la colle cyanocrylate juste avant l'étape de pressage, et en tout cas après le dépôt du premier moyen de collage. On comprend, qu'ainsi la colle conserve son potentiel maximal de polymérisation et donc d'accrochage au module lorsque ce dernier vient être inséré et pressé contre elle.

Dans l'exemple de mise en oeuvre, les figures 7 à 12 peuvent représenter aussi bien des étapes du procédé que des postes opératoires successifs d'une installation telle que décrite infra.

A un premier poste (figure 7) et selon une première étape a), on dépose d'abord une goutte de résine 11b au centre de la cavité à l'aide de moyens de dispense 16, puis on transfère la carte au poste suivant (figure 8).

A ce poste et selon une deuxième étape b), on dépose quatre gouttes de colle cyanocrylate 12b à 14b dites latérales dans les quatre angles de l'évidement supérieur à l'aide d'autres moyens de dispense 17 et 18, et la carte est transférée à un poste dit d'insertion (figure 10).

Au poste d'insertion, selon une autre étape du procédé d), on vient insérer un module électronique 5, à l'aide de moyens d'insertion 19, le temps d'insertion étant dans cet exemple de 300 ms mais il pourrait être réduit encore, et la carte est transférée au poste de pressage (figure 11) ou (selon une alternative préférée: figure 12).

Au poste de pressage (figure 11), selon une autre étape du procédé e), on vient presser les moyens de collage en appliquant une force égale à environ 34 daN pendant une durée de 22 secondes à l'aide de moyens presseurs 20a.

Selon l'alternative de pressage préférée, et selon une étape f), on effectue le pressage uniquement sur la périphérie des plages de contact à l'aide de moyens de pressage 20b, ce qui a pour avantage de presser convenablement la colle sans risquer d'introduire des contraintes mécaniques qui pourraient endommager la pastille semi-conductrice ou des fils de liaison.

En effet, comme déjà expliqué précédemment, le bossage d'enrobage peut avoir des épaisseurs légèrement variables. Dans des cas extrêmes, le bossage peut venir en butée contre le fond de la cavité et créer de ce fait un point central du module légèrement plus élevé que les plages de contact qui, elles, affleurent la surface du corps de carte. De telles configurations fréquemment rencontrées dans une fabrication industrielle interdisent d'appliquer la pression nécessaire à un collage de bonne qualité.

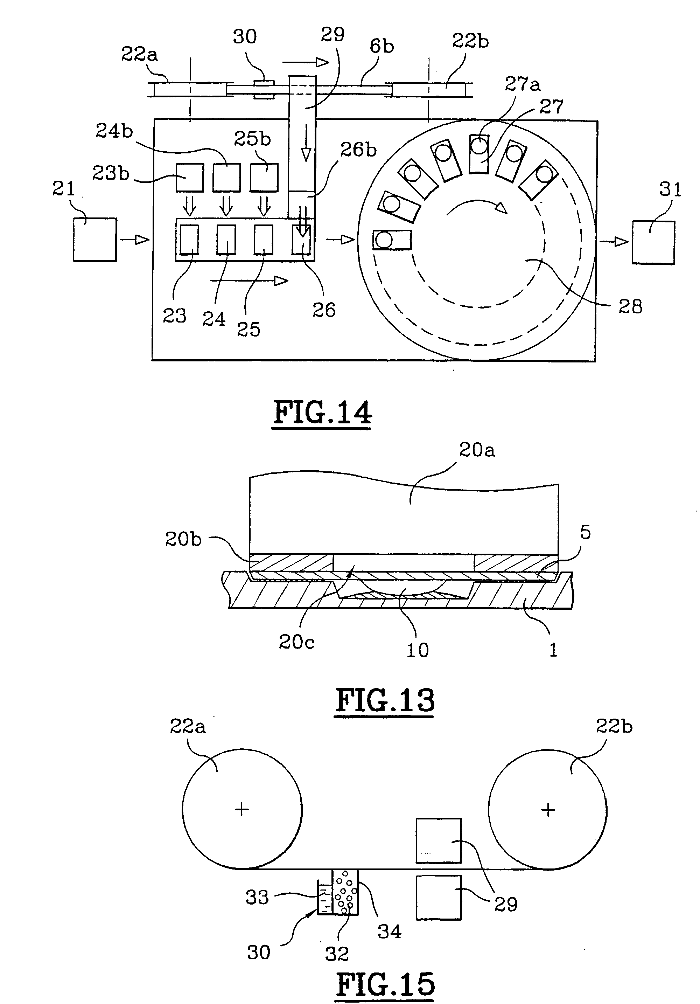

Un exemple de moyens de pressage 20b utilisables est décrit infra à la figure 13.

A l'étape suivante (non illustrée), la carte est évacuée ou subit un traitement préalable, ce qui termine l'opération d'encartage.

Conformément à une caractéristique avantageuse du procédé, on met en oeuvre la matière du deuxième moyen de collage de manière qu'elle produise ses effets de résistance aux efforts d'arrachement et/ou de flexion/ torsion.

Bien que la résine remplisse parfaitement sa fonction de maintien du module sans avoir été exposée au rayonnement ultraviolet, il est préférable de la durcir, ne serait ce que pour éviter des micro-fuites nuisibles situées sous les plages de contact entre deux empreintes ou surfaces d'adhérences 12c à 15c (figure 6). En durcissant, certaines matières visqueuses comme la résine ci-dessus ou un gel de colle cyanocrylate présentent avantageusement des propriétés de résistance mécanique à des efforts d'arrachement et/ou de flexion torsion.

Dans le cas où on utilise la résine époxyde, le procédé selon le premier mode de mise en oeuvre comprend une étape supplémentaire au cours de laquelle on active la polymérisation en soumettant ladite résine époxyde à un rayonnement ultraviolet, cette étape intervenant préalablement à l'insertion du module.

Dans l'exemple, cette étape est réalisée à la figure 9 de préférence juste après l'étape de dépose de la goutte de résine décrite ci-dessus.

L'intensité et la durée de l'exposition sont réglées ici de telle sorte que le temps d'ouverture de la résine soit supérieur à 60 secondes, ce temps correspondant à celui de la colle cyanocrylate utilisée. Pour une application industrielle avec des cadences telles que visées supra, la durée d'exposition varie de 0,5 à 1 seconde. L'intensité peut être modulée tant par la puissance de l'ampoule utilisée que par la distance la séparant de la résine.

Alternativement, l'insolation de la résine peut être effectué au plus tard en même temps que la dépose des gouttes de colle en cyanocrylate.

On comprend ainsi que le laps de temps séparant l'activation des premier et deuxième moyens de collage, de l'étape de pressage, est réduit au minimum, un seul poste la séparant du poste de pressage, ce qui permet d'effectuer un collage de meilleure qualité puisque le temps de pressage sera maximal par rapport au temps d'ouverture de chaque moyen de collage.

On va maintenant décrire les différentes étapes du procédé de l'invention conformément à un deuxième mode de mise en oeuvre.

On utilise, dans ce deuxième mode de mise en oeuvre, un gel de colle cyanocrylate à la place de la résine époxyde.

Ce gel a également des propriétés susceptibles de permettre le maintien du module lorsqu'il est soumis à des forces l'incitant à se décentrer pendant la fabrication.

Il est mis en oeuvre en un volume identique et en suivant des étapes de dépose similaires à celles utilisées pour la résine époxyde, à la différence qu'il n'y a pas dans ce cas d'étape supplémentaire pour l'activation du moyen de collage. En effet, l'activation du gel s'effectue comme pour la colle cyanocrylate, en particulier par les conditions opératoires en température et en hygrométrie identiques.

On comprend que l'activation de ce deuxième moyen est plus aisée à mettre en oeuvre et plus économique. Il n'y a pas en effet de moyens générateurs de rayonnement ultraviolet à mettre en oeuvre, lesquels sont particulièrement coûteux.

D'autres moyens d'activation connus de l'homme du métier sont également possible. Ainsi par exemple, on peut traiter le film du module par un mouillage à l'alcool de manière à activer la polymérisation du gel de colle cyanocrylate au contact du module. De tels moyens sont décrits à la figure 15.

Les étapes d'insertion et de pressage sont identiques à celles décrites pour la résine.

On va maintenant décrire un exemple d'installation pour une mise en oeuvre industrielle à cadence élevée du procédé selon l'invention en référence à la figure 14.

Elle comporte des moyens d'approvisionnement en cartes 21 pour fournir une pluralité de corps de cartes, des moyens d'approvisionnement en modules 22a, 22b pour fournir une pluralité de modules, un poste de dispense de gouttes de résine 23 équipé de moyens de dispense de résine 23b, un poste d'insolation à un rayonnement ultraviolet 24 équipé de moyens d'insolation ultraviolet 24b, un poste 25 de dispense de gouttes de colle cyanocrylate équipé de moyens de dispense 25b comportant deux aiguilles 16 et 17, un poste 26 d'insertion du module équipé de moyens d'insertion 26b, des postes de pressage 27 équipés de moyens presseurs 27a disposés en périphérie d'un carrousel 28 où les cartes peuvent séjourner durant le temps de pressage, des moyens 29 de découpe et de transfert des modules vers le poste d'insertion, des moyens 30 de mouillage à l'alcool le cas échéant, puis des moyens d'évacuation 31. L'installation comprend également une enceinte à atmosphère contrôlée en température et hygrométrie (non représentée).

Les moyens d 'approvisionnement sont constitués par deux bobines, une première bobine 22a chargée d'un film 6a portant les modules et une seconde bobine 22b portant le film dépourvu des modules, l'une se déroulant pendant que l'autre s'enroule. Le film passe le cas échéant par les moyens de mouillage à l'alcool 30 décrit ci-après, avant de passer par les moyens de découpe du module 29.

Les moyens 23 de dispense de la résine comportent une aiguille creuse 16 mobile verticalement.

Le poste d'insolation est relié à des moyens de génération de rayonnement ultraviolet (UV) de type connu par des moyens optiques allongés 32 (figure 9) aptes à véhiculer le rayonnement (UV) jusqu'à proximité de la résine de manière à exposer uniquement la cavité au rayonnement, certaines impressions de la carte étant sensibles au rayonnement ultraviolet.

Les moyens de dispense de la colle cyanocrylate comprennent deux aiguilles creuses 17, 18 (figure 8) qui peuvent se déplacer verticalement et transversalement.

Les modules sont extraits du film 6a par les moyens de découpe et conduits à l'aide des moyens de transfert 29 vers le poste d'insertion où ils sont insérés de manière centrée dans la cavité de chaque carte. C'est notamment à l'opération de découpe du film que des contraintes résiduelles sont libérées et sont responsables de l'incurvation du module comme expliqué supra.

Chaque poste de pressage 27 est muni de moyens presseurs 27a, comportant une extrémité 20a (figure 13) mobile verticalement qui vient en contact du module. Afin de mettre en oeuvre le pressage de manière optimale, cette extrémité est munie d'un blanchet 20b troué au centre permettant d'exercer la pression uniquement en périphérie du module. Le blanchet est en matière élastomère apte à répartir la pression sans altérer les plages de contact. Il possède une forme rectangulaire correspondant à la forme du module. Le diamètre du trou central 20c correspond sensiblement au diamètre du deuxième évidement.

Les moyens 30 (figure 15) de mouillage à l'alcool de la surface inférieure du module sont constitués dans cet exemple, par une éponge 32 plongeant dans un bain 33 d'alcool éthylique à 95° contenu dans un récipient. L'éponge est maintenue en permanence au contact du film d'alimentation en modules. Ces moyens permettent d'activer la colle-cyanocrylate ou le gel de manière à créer un accrochage immédiat au module et/ou de rétablir des différences d'accrochage de la colle ou du gel par rapport au module et la carte.

Des moyens de déplacement des cartes d'un poste à l'autre sont mécanisés de manière à permettre une cadence égale à au moins 2000 cartes à l'heure.

### Fonctionnement.

Lorsqu'une carte arrive en position au poste 23 de dispense de résine, l'aiguille de dispense 16 est positionnée au dessus de l'endroit du point central 11a correspondant au tracé prévu (figure 5), puis, elle descend à proximité de la surface de la cavité, et un système de contrôle (non représenté) commande la délivrance de 0,003 gamme de résine qui se dépose dans la cavité; ensuite, l'aiguille remonte de manière à rompre un fil de résine résiduel qui à tendance à s'accrocher à l'aiguille et se remet en position d'attente de la carte suivante. Les moyens de contrôle sont réglés de manière à permettre une descente, dispense, et remontée en 1,5 secondes; ensuite les cartes sont transférées au poste d'insolation 24.

A ce poste, la résine est exposée à un rayonnement ultraviolet (UV) pendant une durée de 0,5 à 1 seconde de manière à permettre un temps d'ouverture de la résine de 60 secondes, et les cartes sont transférées au poste 25 de dispense de gouttes de cyanocrylate.

Au poste de dispense, deux aiguilles 17 et 18 se positionnent aux points 12a à 15a correspondant au tracé prévu, descendent, dispensent quatre gouttes de 0,001 gramme qui se déposent sur la cavité, puis remontent et se mettent en attente des cartes suivantes, et les cartes sont transférées au poste d'insertion 26b.

A ce poste les cartes reçoivent un module, le temps d'insertion étant de 300 ms et les cartes sont transférées au poste de pressage 27.

A ce poste, chaque module est pressé contre le corps de carte, la force appliquée étant de 34 daN. Les cartes séjournent 22 secondes sur le carrousel, puis elles sont éjectées au poste suivant.

A la sortie du carrousel, les cartes sont éventuellement testées et évacuées vers des moyens de stockage 31.

## Revendications

1. Procédé de réalisation d'une carte à module électronique selon lequel on fournit un corps de carte (1) muni d'une cavité (2), un module électronique (5) de dimensions correspondant à ladite cavité, au moins un premier moyen de collage (12c à 15c) apte à adhérer au corps de carte et au module, on dépose au moins ledit premier moyen de collage dans ladite cavité ou sur le module, on insère ledit module dans la cavité dans une position sensiblement centrée et on presse au moins ledit premier moyen de collage entre le corps de carte et le module, caractérisé en ce qu'il comporte en outre une étape consistant :
- à utiliser un deuxième moyen de collage (11b) présentant des propriétés gluantes et permettant de maintenir le centrage du module (5) dans la cavité au moins jusqu'à ce que ledit premier moyen de collage soit pressé.

2. Procédé selon la -revendication 1, caractérisé en ce qu'on sélectionne le deuxième moyen de collage parmi les matières aptes après traitement à résister à des efforts d'arrachement et/ou de flexion/torsion, et on met en oeuvre ladite matière de manière qu'elle produise ses effets de résistance à de tels efforts.

3. Procédé selon la revendication 1 ou 2, caractérisé en ce qu'on utilise une résine époxyde photo-activable mono-composant en tant que deuxième moyen de collage.

4. Procédé selon la revendication 1 ou 2, caractérisé en ce qu'on utilise un gel de colle cyanocrylate en tant que deuxième moyen de collage.

5. Procédé selon la revendication 3, caractérisé en ce que la résine a une viscosité de 50 P/seconde.

6. Procédé selon la revendication 3, caractérisé en ce qu'on dépose une goutte de 0,003 gramme au centre de la cavité, et on expose la résine au rayonnement de manière que son temps d'ouverture soit supérieur ou égal à environ 60 secondes.

7. Procédé selon la revendication 4, caractérisé en ce qu'on dépose une goutte de gel au centre de la cavité, les conditions de température et d'hygrométrie étant comprises respectivement entre 18 et 24°C et entre 60 et 75 %.

8. Procédé selon l'une quelconque des revendications précédentes, caractérisé en ce qu'on utilise une colle du type cyanocrylate en tant que premier moyen de collage.

9. Procédé selon la revendication 8, caractérisé en ce qu'on dépose une quantité du premier moyen de collage permettant de couvrir, après pressage, une surface de collage comprise entre 50 et 100 % de la surface de ladite cavité, ladite colle étant déposée sous forme d'au moins quatre points de colle latéraux (12c à 15c) dans le logement des plages de contact et sous une température comprise entre 18 à 24 °C et un taux hygrométrique compris entre 60 et 75 %.

10. Procédé selon la revendication 8, caractérisé en ce qu'on dépose la colle cyanocrylate juste avant l'étape d'insertion.

11. Procédé selon la revendication 9, caractérisé en ce qu'on choisit une colle cyanocrylate relativement pure, le temps d'ouverture de la colle cyanocrylate étant supérieur ou égal à environ 60 secondes.

## Claims

1. A method for making an electronic module card in which a card body (1) with a cavity (2) is provided with an electronic module (5) whose dimensions match said cavity, and in which at least a first gluing means (12c to 15c) is adherable to the card body and to the module, at least said first gluing means is deposited in said cavity or on the module, said module is inserted into the cavity in a substantially centered position, and at least said first gluing means is pressed between the card body and the module, characterized in that it additionally has the following step:
- using a second gluing means (11b) being able to exhibit gluing properties and making it possible to keep module (5) centered in the cavity at least until said first gluing means is pressed.

2. A method according to Claim 1, characterized in that the second gluing means is selected from materials able, after processing, to withstand separating and/or bending/twisting forces and said material is used in a way that produces its effects of withstanding such forces.

3. A method according to Claim 1 or 2, characterized in that a single-component light-curable epoxy resin is used as the second gluing means.

4. A method according to Claim 1 or 2, characterized in that a cyanoacrylate glue gel is used as the second gluing means.

5. A method according to Claim 3, characterized in that the resin has a viscosity of 50 Pa/second.

6. A method according to Claim 3, characterized in that a drop of 0.003 gram is deposited in the center of the cavity, and the resin is exposed to radiation so that its open time is greater than or equal to approximately 60 seconds.

7. A method according to Claim 4, characterized in that a drop of gel is deposited in the center of the cavity, the temperature and relative humidity conditions being between 18 and 24°C and between 60 and 75%, respectively.

8. A method according to any one of the preceding claims, characterized in that a glue of the cyanoacrylate type is used as the first gluing means.

9. A method according to Claim 8, characterized in that the quantity of the first gluing means deposited is such that, after pressing, a gluing area of between 50 and 100% of the area of said cavity is covered, said glue being deposited in the form of at least four lateral glue dots (12c to 15c) in the location of the contact pads at a temperature of 18 to 24°C and a relative humidity of between 60 and 75%.

10. A method according to Claim 8, characterized in that the cyanoacrylate glue is deposited just before the insertion step.

11. A method according to Claim 9, characterized in that a relatively pure cyanoacrylate glue is chosen, the open time of the cyanoacrylate glue being greater than or equal to approximately 60 seconds.

## Patentansprüche

1. Verfahren zur Herstellung einer Karte mit Elektronikmodul, bei welchem ein Kartenkorpus (1) mit einer Vertiefung (2), mit einem Elektronikmodul (5), dessen Abmessungen der Vertiefung entsprechen, mit mindestens einem ersten Klebmittel (12c bis 15c), das an dem Kartenkorpus und an dem Modul zur Anhaftung bringbar ist, zugeführt wird, zumindest das erste Klebmittel in die Vertiefung bzw. auf das Modul aufgetragen wird, das Modul in die Vertiefung in einer im wesentlichen zentrierten Position eingesetzt wird und zumindest das erste Klebmittel zwischen dem Kartenkorpus und dem Modul gepresst wird, dadurch gekennzeichnet, dass es des weiteren einen Schritt umfasst, welcher darin besteht:
- dass ein zweites Klebmittel (11b) verwendet wird, welches Klebeigenschaften besitzt und es ermöglicht, die Zentrierung des Moduls (5) in der Vertiefung zumindest so lange beizubehalten, bis das erste Klebmittel gepresst wird.

2. Verfahren nach Anspruch 1, dadurch gekennzeichnet, dass das zweite Klebmittel unter den Stoffen gewählt wird, welche nach Behandlung gegenüber Abziehkräften und/oder Biege-/Torsionskräften widerstandsfähig sind, und dass der Stoff in der Weise eingesetzt wird, dass er seine Widerstandswirkung gegenüber solchen Kräften entfaltet.

3. Verfahren nach Anspruch 1 oder 2, dadurch gekennzeichnet, dass ein durch Licht aktivierbares Epoxydharz mit einem Betsandteil aus zweites Klebmittel eingesetzt wird.

4. Verfahren nach Anspruch 1 oder 2, dadurch gekennzeichnet, dass ein Gel aus Zyanacrylatklebstoff als zweites Klebmittel eingesetzt wird.

5. Verfahren nach Anspruch 3, dadurch gekennzeichnet, dass das Kunstharz eine Viskosität von 50 P/sec besitzt.

6. Verfahren nach Anspruch 3, dadurch gekennzeichnet, dass in der Mitte der Vertiefung ein Tropfen von 0,003 Gramm aufgebracht wird und dass das Kunstharz in der Weise bestrahlt wird, dass die Zeit zu dessen Auflockerung länger als oder gleich etwa 60 Sekunden ist.

7. Verfahren nach Anspruch 4, dadurch gekennzeichnet, dass in der Mitte der Vertiefung ein Tropfen des Gels aufgebracht wird, wobei die Bedingungen hinsichtlich der Temperatur und der Luftfeuchtigkeit jeweils zwischen 18 und 24 °C sowie zwischen 60 und 75 % liegen.

8. Verfahren nach einem der vorhergehenden Ansprüche, dadurch gekennzeichnet, dass ein Klebstoff von der Art von Zyanacrylat als erstes Klebmittel verwendet wird.

9. Verfahren nach Anspruch 8, dadurch gekennzeichnet, dass das erste Klebmittel in einer solchen Menge aufgebracht wird, die es ermöglicht, nach dem Pressen eine Klebfläche zu bedecken, die zwischen 50 und 100 % der Fläche der Vertiefung beträgt, wobei der Klebstoff in Form von mindestens vier seitlichen Klebstoffpunkten (12c bis 15c) in der Aufnahme der Kontaktbereiche bei einer Temperatur zwischen 18 und 24 °C und einer Luftfeuchtigkeit zwischen 60 und 75 % aufgebracht wird.

10. Verfahren nach Anspruch 8, dadurch gekennzeichnet, dass der Zyanacrylatklebstoff genau vor dem Einsetzschritt aufgebracht wird.

11. Verfahren nach Anspruch 9, dadurch gekennzeichnet, dass ein vergleichsweise reiner Zyanacrylatklebstoff gewählt wird, wobei die Zeit zum Auflockern des Zyanacrylatklebstoffs länger als oder gleich etwa 60 Sekunden ist.
